# EUROPÄISCHE PATENTSCHRIFT

(11) **EP 0 654 815 B1**
(45) Veröffentlichungstag und Bekanntmachung des Hinweises auf die Patenterteilung: **26.05.1999**
(21) Anmeldenummer: 94203385.3
(22) Anmeldetag: 22.11.1994
(51) Int. Cl.: H01L 21/00

(54) **Stützelement eines automatischen Ladetisches einer Belichtungseinheit für Siliziumwafer**
Support for an automatic loading table of an exposure unit for silicon wafer
Support d'une table de chargement automatique d'une unité d'exposition pour galette de silicium

(30) Priorität: 23.11.1993 DE 4339818
(43) Veröffentlichungstag der Anmeldung: 24.05.1995
(73) Patentinhaber: Philips Patentverwaltung GmbH, 22335 Hamburg (DE); Koninklijke Philips Electronics N.V., 5621 BA Eindhoven (NL)
(72) Erfinder: Gakis, Andreas, c/o Philips, D-20097 Hamburg (DE); Busskamp, Ralph, c/o Philips, D-20097 Hamburg (DE)
(74) Vertreter: Volmer, Georg, Dipl.-Ing.

(56) Entgegenhaltungen:
- EP-A- 0 435 774
- US-A- 5 044 752
- PATENT ABSTRACTS OF JAPAN vol. 9 no. 10 (E-290) [1733] ,17.Januar 1985 & JP-A-59 161029 (NIPPON DENKI) 11.September 1984,

## Beschreibung

Die Erfindung betrifft ein Stützelement eines automatischen Ladetisches einer Belichtungseinheit für Siliziumwafer, das einen kreisförmigen Abschnitt hat, mit einem der Führung einer Ladestation angepaßten ersten Außendurchmesser, der kleiner als der eines Siliziumwafers ist,

Bekannte automatische Ladetische von Belichtungseinheiten, wie der UT-Stepper von der Firma Ultratech, USA, weisen einen kreisrunden Abschnitt als Stützelement (Chuck) am Ladetisch auf, dessen größter Durchmesser kleiner ist als der der zu belichtenden Siliziumwafer. Die größte Breite des Stützelementes ist dabei begrenzt, bedingt durch die Breite eines in eine Ladestation hineinführenden Einführschlitzes, also einer Station, in der der Ladetisch bzw. das Stützelement mit einem Siliziumwafer beladen wird, was in der Regel automatisch durchgeführt wird. Nachdem der Siliziumwafer auf dem Ladetisch positioniert ist, verfährt der Ladetisch unter eine Belichtungsstation, bestehend in der Regel aus einer Lichtquelle und einer Maske, die eine scharfe Abbildung auf dem zu belichtenden Siliziumwafer erzeugt. Infolge des Überstehens des Siliziumwafers über den Rand des Stützelementes hinaus, wird der Siliziumwafer im Randbereich nur mangelhaft abgestützt, so daß er insgesamt eine Krümmung aufweist, die am Rand des Siliziumwafers zu einer Defokussierung von ca. 5 bis 20 µm führt. Die Ausfälle beim Belichten derartiger Siliziumwafer liegen somit bei 30 bis 40 %, was den Herstellungsprozeß stark beeinträchtigt.

US-A-5 044 752 und EP-A-0 435 774 offenbaren herkömmliche Ladetische.

Der vorliegenden Erfindung liegt die Aufgabe zugrunde, ein Stützelement für einen automatischen Ladetisch einer Belichtungseinheit für Siliziumwafer gemäß Anspruch 1 anzugeben, welches es ermöglicht, auf einfache Weise und unter Verwendung üblicher Belichtungseinheiten und Ladestationen eine Defokussierung weitgehend zu vermeiden.

Erfindungsgemäß wird diese Aufgabe dadurch gelöst, daß der kreisförmige Abschnitt des Stützelementes am Umfang parallel zur Einführrichtung der Ladestation mindestens teilweise vergrößernde Abschnitte und mit diesen einen zweiten Außendurchmesser aufweist, der etwa dem des Siliziumwafers entspricht, und daß die größte Breite des Stützelements orthogonal zur Einführungsrichtung der des kreisrunden Abschnittes entspricht.

Überraschenderweise hat sich gezeigt, daß der in seinen Abmaßen durch die Ladestation und/oder Belichtungseinheit seitlich beschränkte Ladetisch bzw. dessen Auflagefläche, also dessen Stützelement, für Siliziumwafer erfindungsgemäß derart weitergebildet werden kann, daß die Ausfälle durch Verkrümmung der Siliziumwafer von bisher ca. 30 bis 40 % auf weniger als 5 % verringert werden können.

Erfindungsgemäß wird hierzu das Stützelement des Ladetisches nicht in seiner Breite verändert, sondern im wesentlichen nur in seiner Länge, so daß eine z.B. vorhandene Ladestation mit schmalem Einführschlitz auch von dem erfindungsgemäßen Stützelement benutzt werden kann, ohne daß das Stützelement im Einführschlitz der Ladestation anstößt oder verkantet.

Das parallel zur Einführrichtung vergrößerte Stützelement des Ladetisches kann überraschenderweise mit äußerst einfachen Mitteln vergrößert werden. Es hat sich nämlich gezeigt, daß das Stützelement bzw. die Auflagefläche teilweise kreisrund mit einem kleineren Durchmesser als der des Siliziumwafers selbst gewählt werden kann, sofern kreisringförmige Sektoren in Einführrichtung die Auflagefläche des Stützelements vergrößern. Die ringförmigen Sektoren können dabei in Umfangsrichtung auch noch unterbrochen sein, was einer besonderen Ausgestaltung der Erfindung entspricht.

Wie Untersuchungen gezeigt haben, beeinflussen diese ringförmigen Sektoren auch den weiterhin nicht abgestützten Rand seitlich der Auflagefläche des Stützelements positiv, so daß Fokussierungsausfälle von weniger aus als 5 % entstehen.

Weitere vorteilhafte Ausgestaltungen der Erfindung ergeben sich aus den Unteransprüchen.

Ein Ausführungsbeispiel der vorliegenden Erfindung wird nachfolgend unter Bezugnahme auf eine Zeichnung näher erläutert. Darin zeigt:
- Fig. 1: eine Seitenansicht eines Ladetisches mit erfindungsgemäßem Stützelement, und
- Fig. 2: eine Draufsicht auf das erfindungsgemäße Stützelement des Ladetisches nach Fig. 1.

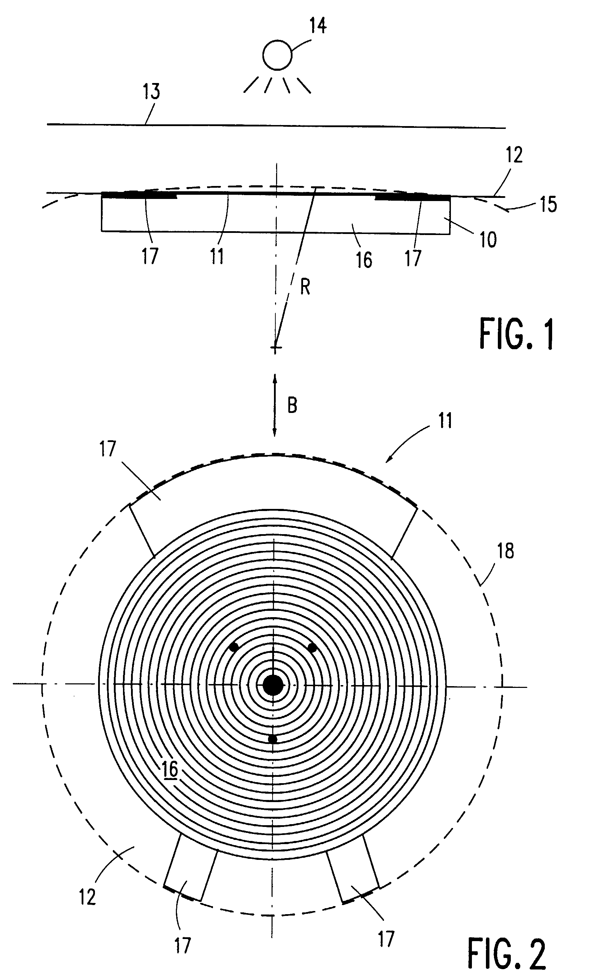

Fig. 1 zeigt einen Ladetisch 10 mit einem Stützelement 11 in einer Seitenansicht, auf dem ein ideal unverkrümmter Siliziumwafer 12 angeordnet ist. Gestrichelt ist ein zu vermeidender gekrümmter Siliziumwafer 15 angedeutet, um die Wirkung des erfindungsgemäßen Stützelementes 11 gegenüber dem Stand der Technik zu veranschaulichen.

Oberhalb des Siliziumwafers 12 ist in einiger Entfernung eine Maske 13 und darüber eine Lichtquelle 14 angeordnet, um den mit einer nicht weiter dargestellten Isolations- und Fotolackschicht versehenen Siliziumwafer 12 zu belichten. Der Ladetisch 10 führt mit einer Bewegung, die in die Zeichnungsebene hineinweist den Siliziumwafer 12 in die richtige Position unter die Maske 13, nachdem der Ladetisch 10 in der Zeichnungsebene seitlich verschwenkt und mit einer Bewegung ebenfalls in die Zeichnungsebene hinein in einer nicht näher dargestellten Ladestation mit dem Siliziumwafer 12 beladen wurde. Nach der Belichtung des Siliziumwafers 12 wird der Ladetisch 10 in entsprechender Weise entladen und neu beladen.

Wie in der Fig. 1 gestrichelt dargestellt ist, weist ein Siliziumwafer 15 bei einem nur kreisrunden Stützelement, entsprechend dem Abschnitt 16 in Fig. 2, wie es im Stand der Technik auch bekannt ist, eine Krümmung mit Radius R auf, da er über den Rand des Abschnittes 16 des Stützelements hinausragt, was zu Defokussierungen insbesondere im Randbereich des Siliziumwafers 15 führt. Das erfindungsgemäße Stützelement 11 weist am kreisrunden Abschnitt 16 Abschnitte 17 auf, die das Stützelement 11 parallel zur Einführrichtung zwar verlängern aber orthogonal dazu nicht verbreitern. Der Siliziumwafer 12 zeigt dann keine Krümmung R.

Fig. 2 zeigt nun die Draufsicht auf ein erfindungsgemäßes Stützelement 11, das in Pfeilrichtung B beispielsweise unter die Maske 13 einer Belichtungseinheit geführt werden kann, aber auch in einen üblicherweise in seiner Breite begrenzten Einführschlitz einer nicht dargestellten Ladestation. Das erfindungsgemäße Stützelement 11 weist dazu einen mittleren kreisrunden Abschnitt 16 auf, dessen Durchmesser, wie im Stand der Technik, kleiner als der des Siliziumwafers 12 ist. In Pfeilrichtung B, also parallel zur Einführrichtung der Ladestation oder Belichtungseinheit, weist die Auflagefläche des erfindungsgemäßen des Stützelements 11 kreisringsektorförmige Abschnitte 17 auf, die in Pfeilrichtung B die Auflagefläche auf den Durchmesser des Siliziumwafers 12 vergrößern. Hierdurch ist gewährleistet, daß das erfindungsgemäße Stützelement 11 mit vergrößerter Auflagefläche in einer üblichen Ladestation wie auch Belichtungsstation verwandt werden kann und gleichzeitig einen großen Teil des Randes des Siliziumwafers 12 abstützt.

Eine Verkrümmung des Siliziumwafers 12 tritt dadurch im Bereich der Abschnitte 17 überhaupt nicht auf, und überraschenderweise auch nicht mehr in den weiterhin nicht abgestützten Randbereichen, in der Fig. 2 links und rechts seitlich des Abschnittes 16. Es kann auch vorgesehen sein, daß der Abschnitt 17, wie in der unteren Hälfte der Fig. 2 dargestellt ist, unterteilt werden kann. Eine derart gestaltete Auflagefläche eines erfindungsgemäßen Stützelementes 11 weist Ausfälle von weniger als 5 % auf. Die in Fig. 2 gestrichelte Linie 18 deutet den äußeren Rand einer Siliziumscheibe 12 an.

## Patentansprüche

1. Stützelement eines automatischen Ladetisches einer Belichtungseinheit für Siliziumwafer, das einen kreisförmigen Abschnitt hat, mit einem der Führung einer Ladestation angepaßten ersten Außendurchmesser, der kleiner als der eines Siliziumwafers ist,
dadurch gekennzeichnet, daß der kreisförmige Abschnitt (16) des Stützelementes (11) am Umfang parallel zur Einführrichtung der Ladestation mindestens teilweise vergrößernde Abschnitte (17) und mit diesen einen zweiten Außendurchmesser aufweist, der etwa dem des Siliziumwafers (12) entspricht, und daß die größte Breite des Stützelements (11) orthogonal zur Einführungsrichtung der des kreisförmigen Abschnittes (16) entspricht.

2. Stützelement nach Anspruch 1,
dadurch gekennzeichnet, daß die den kreisförmigen Abschnitt (16) vergrößernden Abschnitte (17) Kreisringsektoren sind.

3. Stützelement nach Anspruch 2,
dadurch gekennzeichnet, daß die kreisringsektorförmigen Abschnitte (17) in Umfangrichtung mindestens einmal unterteilt sind.

4. Stützelement nach einem oder mehreren der vorhergehenden Ansprüche,
dadurch gekennzeichnet, daß die Auflagefläche des Stützelements (11), bestehend aus dem kreisförmigen Abschnitt (16) und den kreisringsektorförmigen Abschnitten (17) ein nachrüstbares Zubehörelement eines Ladetisches (10) ist.

## Claims

1. A support element of an automatic load platform of a silicon wafer exposure unit, which element has a circular cross-section with a first outer diameter which is adapted to the guide of a load station and which is smaller than that of a silicon wafer,
characterized in that the circular disc (16) of the support element (11) has at its circumference parallel to the insertion direction of the load station at least partly enlarged portions (17) and therewith a second outer diameter which corresponds approximately to that of the silicon wafer (12), and in that the greatest width of the support element (11) at right angles to the insertion direction corresponds to that of the circular disc (16).

2. A support element as claimed in claim 1, characterized in that the portions (17) which enlarge the circular disc (16) are sectors of a circular ring.

3. A support element as claimed in claim 2, characterized in that the portions (17) in the form of sectors of a circular ring are subdivided at least once in circumferential direction.

4. A support element as claimed in any one or several of the preceding claims, characterized in that the support surface of the support element (11), comprising the circular disc (16) and the portions (17) in the shape of sectors of a circular ring, forms an exchangeable accessory of a load platform (10).

## Revendications

1. Elément de support d'une table de chargement automatique d'une unité exposition pour galette de silicium qui présente une section circulaire avec un premier diamètre exteme adapté au guidage d'une station de chargement qui est inférieur à celui d'une galette de silicium, caractérisé en ce que la section circulaire (16) de l'élément de support (11) présente sur sa périphérie des sections (17) agrandies, du moins en partie, parallèlement au sens d'introduction de la station de chargement et forment avec ceux-ci un deuxième diamètre extérieur qui correspond approximativement à celui de la galette de silicium (12) et que la largeur maximale de l'élément de support (11) correspond en direction orthogonale par rapport au sens d'introduction à celui de la section circulaire (16).

2. Elément de support selon la revendication 1, caractérisé en ce que les sections (17) qui agrandissent la section (16) circulaire sont des secteurs d'anneau de cercle.

3. Elément de support selon la revendication 2, caractérisé en ce que des sections en forme de secteur d'anneau de cercle (17) sont subdivisées du moins une fois en direction périphérique.

4. Elément de support selon une ou plusieurs des revendications précédentes, caractérisé en ce que la surface d'application de l'élément de support (11), composée d'une section circulaire (16) et des sections en forme de secteur d'anneau de cercle (17) est un accessoire d'une table de chargement (10) susceptible d'être montée ultérieurement.
